# EUROPÄISCHE PATENTSCHRIFT

(11) **EP 0 923 195 B1**
(45) Veröffentlichungstag und Bekanntmachung des Hinweises auf die Patenterteilung: **30.03.2005**
(21) Anmeldenummer: 98123393.5
(22) Anmeldetag: 09.12.1998
(51) Int. Cl.: H03J 1/00

(54) **Empfänger zum Empfang von DAB-Signalen**
Receiver capable of receiving DAB signals
Récepteur de recevoir des signaux DAB

(30) Priorität: 09.12.1997 DE 19754401
(43) Veröffentlichungstag der Anmeldung: 16.06.1999
(73) Patentinhaber: ROBERT BOSCH GMBH, 70442 Stuttgart (DE)
(72) Erfinder: Wendland, Arnd, 31199 Diekholzen (DE)

(56) Entgegenhaltungen:
- EP-A- 0 610 313
- EP-A- 0 732 821
- WO-A-97/23967
- DE-A- 4 136 068
- GB-A- 2 295 062

## Beschreibung

Die Erfindung betrifft einen Empfänger zum Empfang von DAB-Signalen, wobei ein empfangener Datenstrom außer Programmen Zusatzinformationen enthält.

Beim DAB (Digital Audio Broadcasting) werden nicht nur Programme, sondern auch eine Vielzahl von Zusatzinformationen übertragen. Diese enthalten beispielsweise Programmtyp-Kennungen, an denen der Benutzer eines Empfängers erkennen kann, welche Art des Programms der jeweilige Sender ausstrahlt, so daß er nach diesen Informationen Sender selektieren kann oder bereits beim Empfang von Nachrichten weiß, welche Art des grundsätzlichen Programms (Unterhaltungsmusik, ernste Musik, Sport) nach dem Ende der Nachrichten zu erwarten ist. Das Dokument EP-A-0 610 313 veröffentlicht einer Rundfunkempfängen, der auch DAB Signale auswertet.

Ferner ist den Zusatzinformationen entnehmbar, welche Durchsagearten unterstützt werden, beispielsweise Verkehrsfunkdurchsagen. Zu den Zusatzinformationen gehören auch Angaben über alternative Frequenzen, d. h. andere Frequenzen, auf denen dasselbe Programm empfangen werden kann. Diese Angaben können andere Frequenzen innerhalb des DAB-Systems, aber auch Frequenzen von herkömmlichen UKW-Sendern (FM-Frequenzen) sein. Aufgrund ihres Ursprungs werden im DAB auch Programme zu sogenannten Ensembles zusammengefaßt, beispielsweise die verschiedenen Programme einer Rundfunkanstalt. Außerdem können Programme aus mehreren Komponenten bestehen. Bei mehreren Audio-Komponenten können diese verschiedene Sprachen betreffen. Audio-Programme können ferner auch Daten-Komponenten enthalten.

Bei bekannten Empfängern werden die Zusatzinformationen, wie sie beispielsweise beim RDS (Radiodatensystem) übertragen werden, nur in äußerst kurzer Form angezeigt, insbesondere der Name des Senders oder ob der jeweilige Sender Verkehrsinformationen ausstrahlt.

Aufgabe der Erfindung ist es, dem Benutzer Zusatzinformationen zugänglich zu machen, die insbesondere zur Unterstützung der Bedienung genutzt werden können.

Diese Aufgabe wird erfindungsgemäß dadurch gelöst, daß Mittel zur Ausgabe der Zusatzinformationen vorgesehen sind.

Stehen dabei Mittel zur Verfügung, insbesondere ein entsprechend großes Display, so können bei einem Empfänger, bei dem die Zusatzinformationen aus Gruppen mit jeweils mehreren Informationseinheiten (Programmtyp-Kennungen, Hinweise auf andere Ensembles, Hinweise auf alternative Frequenzen und/oder gleiche Programme auf FM-Frequenzen, Durchsagearten) bestehen, mehrere Informationseinheiten mindestens einer Gruppe jeweils gleichzeitig ausgebbar sein.

Bei einer anderen Ausgestaltung eines erfindungsgemäßen Empfängers für DAB-Signale ist vorgesehen, daß aus den empfangenen Zusatzinformationen zur Ausgabe mindestens eine Informationseinheit durch geeignete Eingaben auswählbar ist.

Damit können auch kleinere Displays verwendet werden oder eine Sprachausgabe auf einen oder wenige Sätze beschränkt werden, wobei der Benutzer durch die Bedieneingabe entsprechende weitere Informationen unmittelbar erhält.

Dazu kann vorzugsweise vorgesehen sein, daß die Eingaben zur Auswahl einer Gruppe und zur Auswahl mindestens einer Informationseinheit innerhalb der jeweils ausgewählten Gruppe dienen. Eine einfache Bedienung ist bei dieser Ausgestaltung dadurch möglich, daß jeweils mindestens ein Bedienelement zur Auswahl aus den Gruppen und zur Auswahl der mindestens einen Informationseinheit innerhalb der ausgewählten Gruppe vorgesehen ist.

Eine Begrenzung der Anzahl der Bedienelemente insgesamt ist dadurch möglich, daß die Bedienelemente auch für andere Eingaben vorgesehen sind und durch eine vorherige Betätigung eines Umschaltbedienelementes zur Auswahl der Gruppen bzw. Informationseinheiten umgeschaltet werden.

Bei einer Weiterbildung der Erfindung ist vorgesehen, daß anhand der jeweils zugeordneten Zusatzinformationen die Anzeige und Auswahl aus mehreren Komponenten eines Programms möglich sind. Dabei kann beispielsweise die Anzeige, daß zu einem in einer ersten Sprache empfangenen Programm noch eine Komponente in einer zweiten Sprache gesendet wird, dazu benutzt werden, auf die zweite Sprache umzuschalten.

Das DAB-System gestattet auch, einzelne Programm-Komponenten zu verschlüsseln, so daß sie nur von bestimmten Empfängern entschlüsselbar sind. Um generell eine Information von dem Vorhandensein derartiger Programm-Komponenten zu ermöglichen, ist bei einer anderen Weiterbildung vorgesehen, daß Zusatzinformationen zu verschlüsselten Komponenten anzeigbar sind. Diese Komponenten selbst sind dann nur nach entsprechender Entschlüsselung nutzbar.

Sofern eine Komponente eines Programmes Daten betrifft - im Gegensatz zu den übertragenen Audiodaten - kann bei einer Ausgestaltung des erfindungsgemäßen Empfängers vorgesehen sein, daß die Daten anzeigbar sind.

Vorzugsweise ist bei dem erfindungsgemäßen Empfänger vorgesehen, daß die Anzeige durch ein separates Bedienelement aktivierbar ist. Es ist jedoch auch möglich, die Anzeige durch eine Spracheingabe zu aktivieren.

Bei dem erfindungsgemäßen Empfänger kann die Ausgabe textuell oder in Form einer Sprachausgabe erfolgen.

Ein Ausführungsbeispiel der Erfindung ist in der Zeichnung dargestellt und in der nachfolgenden Beschreibung näher erläutert.

Das Ausführungsbeispiel weist eine Antenne 1, ein Empfangsteil 2, eine NF-Aufbereitungsschaltung 3, einen NF-Verstärker 4 und einen Lautsprecher 5 auf, wobei der Übersichtlichkeit halber auf die Darstellungen von Einzelheiten, wie beispielsweise mehrere Lautsprecher für Stereo-Wiedergabe, Stereo-Decoder, RDS-Decoder usw., verzichtet wurde. Mit einem Controller 6, an den eine Tastatur 8 angeschlossen ist, werden u.a. sämtliche Funktionen des Empfängers gesteuert - beispielsweise Senderwahl und Lautstärkeeinstellung. An den Controller 6 ist ferner ein Display 9 angeschlossen, auf welchem die jeweiligen Einstellungen und weitere Informationen sichtbar gemacht werden können. Außerdem ist bei den Ausführungsbeispielen eine Sprachausgabeeinheit 10 an den Controller 6 angeschlossen, deren Ausgangssignale über den NF-Verstärker 4 und den Lautsprecher 5 hörbar gemacht werden.

Das Empfangsteil 2 gibt an seinem Ausgang je nach eingestelltem Sender DAB-Signale oder NF-Signale der herkömmlichen Rundfunksender ab. Letztere werden der NF-Aufbereitungsschaltung 3 zugeführt, die insbesondere einen Demodulator und einen Stereo-Decoder enthält. Die DAB-Signale gelangen über einen Decoder 7 zum Controller 6. Dieser führt diejenigen Daten, welche Programme betreffen, als NF-Signale dem NF-Verstärker 4 zu und verarbeitet die Zusatzinformationen. Mit Hilfe der Tastatur 8 können aus den Zusatzinformationen solche, die angezeigt werden sollen, selektiert werden. Die selektierten Zusatzinformationen werden dann vom Controller 6 dem Display 9 und/oder der Sprachausgabeeinheit zugeführt.

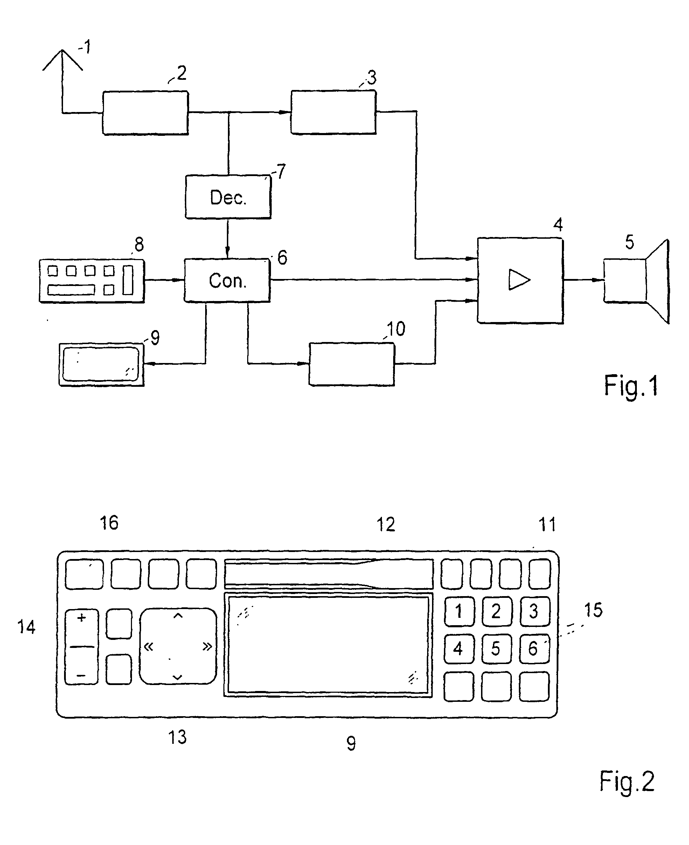

Fig. 2 zeigt die Ansicht eines Ausführungsbeispiels, das als Autoradio ausgebildet ist. Auf der Frontplatte 11 des Autoradios befinden sich das Display 9, eine Aufnahmeöffnung 12 eines im übrigen nicht dargestellten Kassettenspielers, eine Kreuzwippe 13, eine Wippe 14 zur Einstellung der Lautstärke, Stationstasten 15 und eine Taste 16, mit welcher die Darstellung der Zusatzinformationen auf dem Display 9 gestartet werden kann. Weitere an sich übliche Bedienelemente zur Bedienung des Autoradios einschließlich des Kassettenspielers sind bekannt und brauchen zur Darstellung der Erfindung nicht näher erläutert zu werden.

Die Kreuzwippe 13 kann wie bei einem bekannten Autoradio je nach Betriebszustand zur Senderwahl oder zur Steuerung anderer Funktionen benutzt werden. Bei dem dargestellten Ausführungsbeispiel, das bereits über ein verhältnismäßig großes Display 9 verfügt, können mehrere Informationseinheiten, beispielsweise auch zwei oder drei Programmtyp-Kennungen dargestellt werden. Da jedoch die DAB-Signale eine wesentlich höhere Anzahl von Informationseinheiten aufweisen, die für den Benutzer von Interesse sein können, ist bei dem Ausführungsbeispiel vorgesehen, daß nach Betätigen der Taste 16 zunächst einige voreingestellte Informationseinheiten auf dem Display 9 erscheinen - beispielsweise die Programmtyp-Kennungen "U-Musik" und "Nachrichten". Der Benutzer weiß dann, daß er einen Sender eingestellt hat, der regelmäßig Unterhaltungsmusik und ebenfalls regelmäßig Nachrichten ausstrahlt.

Möchte jedoch der Benutzer wissen, ob von diesem Sender auch spezielle Sportbeiträge gebracht werden, kann er die Kreuzwippe 13 oben oder unten bei den einfachen Pfeilen betätigen und erhält andere in der Liste der Programmtyp-Kennungen aufgeführte Kennungen angezeigt - wie beispielsweise "Sportbeiträge".

Durch Betätigung der Kreuzwippe 13 bei den Doppelpfeilen kann der Benutzer auf andere Gruppen der Zusatzinformationen umschalten - beispielsweise auf die Angaben zu Alternativfrequenzen oder Informationen über andere Programme innerhalb eines Ensembles.

Die Auswahl aus den Zusatzinformationen kann an sich auch mit einer dafür vorgesehenen Spracheingabe erfolgen, beispielsweise kann eine Spracherkennungseinrichtung auf das Wort "Info" reagieren, worauf analog zum Betätigen der Taste 16 die Darstellung der Zusatzinformationen im Display 9 gestartet wird. Durch zusätzliches Sprechen von Namen der gewünschten Informationseinheiten oder Worten wie "auf" und "ab" kann dann die eigentliche Auswahl erfolgen.

## Patentansprüche

1. Empfänger zum Empfang von DAB-Signalen, wobei die empfangenen DAB-Signale neben der Sender- und gegebenenfalls der Programmtypkennung mindestens eine weitere Zusatzinformation beinhalten, wobei die Zusatzinformation aus mindestens einer Gruppe mit mindestens einer Informationseinheit (z. B. Hinweise auf andere Ensembles, Hinweise auf alternative Frequenzen und/oder gleiche Programme auf FM-Frequenzen, Durchsagearten) besteht, wobei die Sender- und gegebenenfalls die Programmtypkennung des ausgewählten Senders und des laufenden Programms automatisch nach der Einstellung des Senders anzeigbar sind, **dadurch gekennzeichnet** und daß am Empfänger mindestens eine Informationseinheit der jeweiligen Gruppe manuell oder durch Spracheingabe auswählbar und akustisch und/oder optisch darstellbar ist.

2. Empfänger nach Anspruch 1, **dadurch gekennzeichnet, daß** die Programme aus höchstens zwölf Komponenten bestehen, wobei in Komponenten der Programme Zusatzinformationen enthalten sind.

3. Empfänger nach Ansprüchen 1 und 2, **dadurch gekennzeichnet, daß** jeweils mindestens ein Bedienelement (13) zur Auswahl mindestens einer Gruppe und mindestens einer Informationseinheit aus der jeweils ausgewählten Gruppe dient.

4. Empfänger nach Ansprüchen 1 bis 3, **dadurch gekennzeichnet, daß** die Bedienelemente (13) auch für andere Eingaben vorgesehen sind und durch eine vorherige Betätigung eines Umschaltbedienelements (16) zur Auswahl der Gruppen bzw. der Informationseinheiten umschaltbar sind.

5. Empfänger nach Ansprüchen 1 bis 4, **dadurch gekennzeichnet, daß** der Benutzer die Auswahl aus und die Anzeige von mehreren Komponenten eines Programms anhand der jeweils zugeordneten Zusatzinformationen durchführt.

6. Empfänger nach Ansprüchen 1 bis 5, **dadurch gekennzeichnet, daß** Zusatzinformationen zu verschlüsselten Komponenten auswählbar und anzeigbar sind.

7. Empfänger nach Ansprüchen 1 bis 6, **dadurch gekennzeichnet, daß** die Anzeige der Zusatzinformationen durch ein Bedienelement ein- und ausgeschaltet wird.

8. Empfänger nach Ansprüchen 1 bis 7, **dadurch gekennzeichnet, daß** die Anzeige der Zusatzinformationen durch Spracheingabe ein- und ausgeschaltet wird.

## Claims

1. Receiver for receiving DAB signals, the received DAB signals containing, besides the station identifier and possibly the programme-type identifier, at least one further additional information item, the additional information item comprising at least one group with at least one information unit (e.g. references to other ensembles, references to alternative frequencies and/or to the same programmes on FM frequencies, announcement types), and the station identifier and possibly the programme-type identifier for the selected station and for the current programme being able to be displayed automatically after the station has been set, **characterized in that** at least one information unit from the respective group can be selected on the receiver manually or using voice input and can be presented audibly and/or visually.

2. Receiver according to Claim 1, **characterized in that** the programmes comprise no more than twelve components, with components of the programmes containing additional information.

3. Receiver according to Claims 1 and 2, **characterized in that** at least one respective control element (13) is used for selecting at least one group and at least one information unit from the respectively selected group.

4. Receiver according to Claims 1 to 3, **characterized in that** the control elements (13) are also provided for other inputs and can be changed over through prior operation of a changeover control element (16) in order to select the groups or the information units.

5. Receiver according to Claims 1 to 4, **characterized in that** the user makes the selection from and displays a plurality of components of a programme using the respectively associated additional information.

6. Receiver according to Claims 1 to 5, **characterized in that** additional information for encrypted components can be selected and displayed.

7. Receiver according to Claims 1 to 6, **characterized in that** the display of the additional information is turned on and off by a control element.

8. Receiver according to Claims 1 to 7, **characterized in that** the display of the additional information is turned on and off by voice input.

## Revendications

1. Récepteur pour la réception de signaux DAB (signaux radionumériques) qui contiennent, en plus de la caractéristique de l'émetteur et le cas échéant du type de programme, au moins une autre information complémentaire,
l'information complémentaire se composant d'au moins un groupe d'au moins une unité d'information (par exemple une indication relative à d'autres ensembles, les indications concernant des fréquences alternatives et/ou les mêmes programmes en fréquence FM, des types de messages) la caractéristique d'émetteur et le cas échéant de type de programme pour l'émetteur sélectionné et le programme en cours une fois le récepteur réglé sur l'émetteur,
**caractérisé en ce que**
sur le récepteur on peut sélectionner au moins une unité d'information du groupe respectif, manuellement ou par commande vocale, et on peut l'afficher en mode acoustique et/ ou optique.

2. Récepteur selon la revendication 1,
**caractérisé en ce que**
les programmes sont formés d'au moins douze composantes et les composants contiennent les informations complémentaires de programme.

3. Récepteur selon les revendications 1 et 2,
**caractérisé en ce que**
chaque fois au moins un élément de commande (13) sert à sélectionner au moins un groupe et au moins une unité d'information dans chaque groupe sélectionné.

4. Récepteur selon les revendications 1 à 3,
**caractérisé en ce que**
les éléments de commande (13) sont multifonctions et sont commutés par l'actionnement préalable d'un élément de commande de commutation (16), pour sélectionner les groupes ou les unités d'informations.

5. Récepteur selon les revendications 1 à 4,
**caractérisé en ce que**
l'utilisateur fait la sélection et assure l'affichage de plusieurs composants d'un programme à l'aide d'informations complémentaires associées.

6. Récepteur selon les revendications 1 à 5,
**caractérisé en ce qu'**
on peut sélectionner et afficher des informations complémentaires concernant des composants codés.

7. Récepteur selon les revendications 1 à 6,
**caractérisé en ce que**
l'affichage des informations complémentaires peut être mis en oeuvre ou coupé par un élément de commande.

8. Récepteur selon les revendications 1 à 7,
**caractérisé en ce qu'**
on branche ou on coupe l'affichage des informations complémentaires par une commande vocale.
